# EUROPÄISCHE PATENTANMELDUNG

(11) **EP 3 573 238 A1**
(43) Veröffentlichungstag der Anmeldung: **27.11.2019**
(21) Anmeldenummer: 19175742.6
(22) Anmeldetag: 21.05.2019
(51) Int. Cl.: H03K 17/96, B29C 45/14, G06F 3/0354, G06F 3/0362

(54) **EINGABEVORRICHTUNG ZUR STEUERUNG EINES ELEKTRONISCHEN GERÄTES UND VERFAHREN ZU IHRER HERSTELLUNG**

(30) Priorität: 25.05.2018 DE 102018112649
(71) Anmelder: Beier, Uwe, 01458 Ottendorf-Okrilla (DE)
(72) Erfinder: Beier, Uwe, 01458 Ottendorf-Okrilla (DE)
(74) Vertreter: Riechelmann & Carlsohn Patentanwälte PartG mbB

(57) **Zusammenfassung**

Die Erfindung betrifft eine Eingabevorrichtung zur Steuerung eines elektronischen Gerätes. Dabei ist vorgesehen, dass die Eingabevorrichtung (1) ein dreidimensionales Formteil (30) aus einer umgeformten Verbundfolie (9, 9') aufweist, wobei die Verbundfolie (9, 9') ein Verbund ist, der eine Kunststoff-Trägerfolie (2), ein oder mehrere Funktionselemente (4, 5, 5a, 21, 22, 41, 42, 43) und eine oder mehrere Leiterbahnen (6, 7, 26, 27, 46, 47, 48) zur elektrischen Kontaktierung der Funktionselemente (4, 5, 5a, 21, 22, 41, 42, 43) aufweist, wobei die Funktionselemente (4, 5, 5a, 21, 22, 41, 42, 43) und die Leiterbahnen (6, 7, 26, 27, 46, 47, 48) auf die Trägerfolie (2) aufgebracht sind, die Funktionselemente (4, 5, 5a, 21, 22, 41, 42, 43) jeweils eine elektrische und/oder elektronische Komponente sind und zumindest eines der Funktionselemente (4, 5, 5a, 21, 22, 41, 42, 43) ein Eingabemittel ist.

## Beschreibung

Die Erfindung betrifft eine Eingabevorrichtung zur Steuerung eines elektronischen Gerätes, insbesondere eines Fahrzeug-Rechnersystems. Sie betrifft ferner ein Verfahren zur Herstellung einer solchen Eingabevorrichtung.

Aus DE 101 31 039 A1 ist eine Eingabevorrichtung zur Steuerung eines Fahrzeug-Rechensystems bekannt. Die Eingabevorrichtung soll die Auswahl von Menüpunkten aus hierarchisch gegliederten Auswahlmenüs ermöglichen, die auf einem Bildschirm, der Teil des Fahrzeug-Rechensystems ist, angezeigt werden. Durch Auswahl eines Menüpunktes kann der Nutzer das Fahrzeug-Rechensystem bedienen. Insbesondere kann er dessen Funktionen, beispielsweise Navigation, Telefonie, Klang- und Bildwiedergabe, Internet und anderes, beeinflussen. Die in DE 101 31 039 A1 beschriebene Eingabevorrichtung weist einen scheibenförmigen Betätigungskörper auf, der von einem Gehäuse um eine Achse drehbar gehalten ist. Um den scheibenförmigen Betätigungskörper drehen oder schwenken zu können, ist eine Griffleiste vorgesehen, die sich über den gesamten Durchmesser des Betätigungskörpers erstreckt. Eine Dreh- oder Schwenkbewegung wird an ein Schaltelement übertragen. Der Betätigungskörper kann durch Drücken verlagert werden. Die Verlagerung wird an ein zweites Schaltelement übertragen. Außerdem weist der Betätigungskörper eine Kippachse auf, wobei eine Kippbewegung auf ein drittes Schaltelement übertragen wird.

Aus DE 197 32 287 A1 ist eine als Multifunktions-Bedieneinrichtung bezeichnete Eingabevorrichtung bekannt, die die Steuerung eines Bordcomputers durch Auswahl von Menüs ermöglichen soll. Die Eingabevorrichtung weist einen Betätigungsknopf auf, der von einem Bediener gedreht, geschwenkt und gedrückt werden kann. Der Betätigungsknopf wirkt mit einem Schaltglied zusammen, das über ein Kugelgelenk in einem Gehäuse gelagert ist. Ferner weist die Eingabevorrichtung mehrere Mikrotaster sowie ein Auslegerelement und Betätigungsarme auf, um die Mikrotaster beim Verschwenken des Betätigungsknopfes betätigen zu können.

Neuere Eingabevorrichtungen zur Steuerung von Fahrzeug-Rechensystemen weisen zusätzlich zu mechanischen Komponenten, die nach wie vor ein Drehen, Schwenken und/oder Drücken eines Betätigungsknopfes ermöglichen sollen, eine berührungsempfindliche Schicht, beispielweise ein sogenanntes Touchpad, auf. Beispielsweise ist aus DE 10 2009 052 928 eine Eingabevorrichtung zur Steuerung von Fahrzeug-Rechensystemen bekannt, die neben einem Touchpad Tasten und einen Dreh-Drück-Steller aufweist. Der Dreh-Drück-Steller ist ein kegelstumpfförmiges Bauteil, das dreh- und kippbar ist und die Auswahl von Menüs ermöglichen soll. Aus DE 10 2010 042 690 A1 ist bekannt, ein Touchpad auf dem Dreh-Drück-Steller anzuordnen.

Die aus dem Stand der Technik bekannten Eingabevorrichtungen weisen eine Vielzahl von Bauelementen auf, um die Drehungen, Schwenkungen und Verschiebungen eines Eingabeelementes, beispielsweise eines Betätigungsknopfes, zu ermöglichen. Die Integration eines Touchpads in die Eingabevorrichtung vergrößert die für eine solche Eingabevorrichtung benötigte Fläche. Im Hinblick auf die kurzen Zeitspannen, die es einem Fahrzeugführer ermöglichen, das Rechnersystem seines Fahrzeuges zu bedienen, ist es jedoch auch nicht zweckmäßig, die Eingabevorrichtung vollständig durch ein Touchpad zu ersetzen. Ein solches Touchpad würde aufgrund seiner Zweidimensionalität die bisher gewohnte Steuerung, die mittels Kippen oder Drehen realisiert wurde, nur schwer ersetzen, weil die Bewegung der Finger weniger zielgenau und damit zeitaufwendiger ist.

Aufgabe der Erfindung ist es, die Nachteile nach dem Stand der Technik zu beseitigen. Es soll insbesondere eine Eingabevorrichtung zur Steuerung eines elektronischen Gerätes angegeben werden, die bei einer geringeren Anzahl von Bauelementen eine leichte, sichere und schnelle Steuerung eines elektronischen Gerätes, beispielsweise eines Rechnersystems eines Fahrzeuges, ermöglicht. Ferner soll ein Verfahren zur Herstellung einer solchen Eingabevorrichtung angegeben werden.

Diese Aufgabe wird durch die Merkmale der Ansprüche 1 und 13 gelöst. Zweckmäßige Ausgestaltungen der Erfindungen ergeben sich aus den Merkmalen der Unteransprüche.

Nach Maßgabe der Erfindung ist eine Eingabevorrichtung zur Steuerung eines elektronischen Gerätes vorgesehen, die ein dreidimensionales Formteil aus einer umgeformten Verbundfolie aufweist. Die Verbundfolie ist ein Verbund, der eine Kunststoff-Trägerfolie, ein oder mehrere Funktionselemente und eine oder mehrere Leiterbahnen zur elektrischen Kontaktierung der Funktionselemente aufweist. Die Funktionselemente und die Leiterbahnen sind auf die Trägerfolie aufgebracht. Die Funktionselemente sind jeweils eine elektrische und/oder elektronische Komponente, wobei zumindest eines der Funktionselemente ein Eingabemittel ist. Bei dem dreidimensionalen Formteil kann es sich um die erfindungsgemäße Eingabevorrichtung handeln. Es kann jedoch vorgesehen sein, dass die erfindungsgemäße Eingabevorrichtung neben dem dreidimensionalen Formteil weitere Elemente aufweist.

Die erfindungsgemäße Eingabevorrichtung kann beispielsweise zur Steuerung des Rechnersystems eines Fahrzeuges eingesetzt werden. Die erfindungsgemäße Eingabevorrichtung besteht aus wenigen Teilen, ist einfach aufgebaut und kann einfach hergestellt werden.

Die erfindungsgemäße Eingabevorrichtung weist ein dreidimensionales Formteil auf, das durch Umformen einer Verbundfolie erhältlich ist. Vorzugsweise weist das erfindungsgemäße Formteil einen hohen Umformgrad auf. Unter einem hohen Umformgrad wird in der vorliegenden Erfindung eine Richtungsänderung verstanden, bei der ein erster Abschnitt des Formteils zu einem zweiten Abschnitt des Formteiles in einem Neigungswinkel verläuft, der größer als 30°, vorzugsweise größer als 45°, bevorzugt größer als 60° und besonders bevorzugt größer als 80° ist. Der Neigungswinkel kann 45°, 60° oder 80° betragen. Der Neigungswinkel kann 90° betragen. Der Neigungswinkel kann durch Messen des Winkels zwischen einer ersten Ebene, in der der erste Abschnitt verläuft, und einer zweite Ebene, in der der zweite Abschnitt verläuft, bestimmt werden, wobei der Neigungswinkel der kleinere der beiden Supplementswinkel zwischen der ersten und der zweiten Ebene ist. Der Neigungswinkel kann also höchstens 90° betragen. Vorzugsweise weist das erfindungsgemäße Formteil nicht nur einen, sondern zwei oder mehr solcher Richtungsänderungen auf. Vor der Umformung der Verbundfolie zu einem Formkörper weist die Verbundfolie keine Richtungsänderungen auf, d. h. die beiden Flächenseiten der Verbundfolie liegen jeweils in einer Ebene. Der zweite Abschnitt kann an den ersten Abschnitt angrenzen, wobei zwischen dem ersten Abschnitt und dem zweiten Abschnitt ein Übergangsbereich ausgebildet sein kann. Ein Übergangsbereich ist ein Bereich, in dem sich die Richtungsänderung zwischen dem ersten Abschnitt und dem zweiten Abschnitt graduell vollzieht.

In einer Ausführungsform der Erfindung weist das Formteil einen Hohlraum auf. Die Wandungen des Hohlraums müssen nicht zwingend als Regelflächen ausgebildet sein. Um insbesondere die Ergonomie der erfindungsgemäßen Eingabevorrichtung zu erhöhen, können Wandungen des Hohlraums Freiformflächen, z. B. konkave und/oder konvexe Freiformflächen sein. Der Hohlraum kann von einer Decke und einem Mantel begrenzt sein. Das Formteil kann eine Basis aufweisen, an die der Mantel angrenzt. Damit ist eine erste Richtungsänderung verbunden. Der Übergang zwischen Mantel und Decke ist mit einer zweiten Richtungsänderung verbunden. Der Hohlraum kann einen kreisförmigen Querschnitt aufweisen. Die Decke, der Mantel und/oder die Basis müssen nicht zwingend als Regelflächen ausgebildet sein. Um insbesondere die Ergonomie der erfindungsgemäßen Eingabevorrichtung zu erhöhen, können die Decke, der Mantel und/oder die Basis Freiformflächen, z. B. konkave und/oder konvexe Freiformflächen sein. Vorzugsweise ist der Mantel eine Freiformfläche. Vorzugsweise sind der Deckel und der Mantel eine Freiformfläche.

Die Trägerfolie ist eine Kunststofffolie. Die Trägerfolie ist vorzugsweise eine flexible Trägerfolie. Die Trägerfolie besteht vorzugsweise aus einem Kunststoff, der sich thermisch umformen lässt. Die Dicke der Trägerfolie kann 1 mm oder weniger, bevorzugt 0,1 mm oder weniger, besonders bevorzugt 500 Mikrometer oder weniger betragen. Die Trägerfolie verleiht dem Formkörper seine Stabilität.

Das Funktionselement ist eine elektrische Komponente und/oder eine elektronische Komponente. Unter einem Funktionselement, das eine elektrische und eine elektronische Komponente ist, wird eine Kombination aus zumindest einer elektrischen Komponente und zumindest einer elektronischen Komponente verstanden. Die Verbundfolie kann mehr als ein Funktionselement aufweisen. Leiterbahnen sind keine Funktionselemente.

Vorzugsweise sind Funktionselemente und Leiterbahnen auf der ersten Flächenseite der Trägerfolie angeordnet, während die zweite Flächenseite der Trägerfolie freiliegt. Das heißt mit anderen Worten, dass die zweite Flächenseite der Trägerfolie vorzugsweise eine Außenseite der erfindungsgemäßen Verbundfolie bildet. Ein Funktionselement kann die erste Flächenseite der Trägerfolie ganz oder teilweise bedecken. Es kann vorgesehen sein, dass ein oder mehrere Funktionselemente sowie eine oder mehrere Leiterbahnen unmittelbar auf der ersten Flächenseite angeordnet sind. Der Begriff "unmittelbar" bedeutet dabei, dass das jeweilige Funktionselement oder die jeweilige Leiterbahn mit einer seiner bzw. ihrer Flächenseiten auf der ersten Flächenseite der Trägerfolie aufliegt. Es können weitere Funktionselemente und/oder Leiterbahnen auf den Funktionselementen und/oder Leiterbahnen, die unmittelbar auf der ersten Flächenseite der Trägerfolie aufliegen, angeordnet sein, wobei zur elektrischen Isolierung übereinander liegende Funktionselemente und/oder Leiterbahnen Isolationsschichten vorgesehen sein können. Es können somit mehrere Funktionselemente und/oder Leiterbahnen, bezogen auf die Ausdehnung der Verbundfolie in Dickenrichtung, übereinander angeordnet sein. Die Verbundfolie kann einen sandwichartigen Aufbau haben.

Ein Funktionselement kann als Funktionsschicht ausgebildet sein. Eine Funktionsschicht besteht aus mehreren, aufeinander liegenden Schichten, die gemeinsam das Funktionselement bilden. Die Ausbildung eines Funktionselementes als Funktionsschicht ermöglicht die Realisierung eines flacheren Funktionselementes, weil die Funktionsschicht eine geringere Ausdehnung in Dickenrichtung der Verbundfolie aufweisen kann als ein Funktionselement, das nicht als Funktionsschicht ausgebildet ist. Es können mehrere Funktionsschichten, bezogen auf die Ausdehnung der Verbundfolie in Dickenrichtung, übereinander angeordnet sein, wobei zur elektrischen Trennung von Funktionsschichten Isolierschichten vorgesehen sein können. Vorzugsweise sind alle Funktionselemente als Funktionsschichten ausgebildet, das ist aber nicht erforderlich. Vielmehr kann die Verbundfolie Funktionselemente aufweisen, die als Funktionsschicht ausgebildet sind, und Funktionselemente, die nicht als Funktionsschicht ausgebildet sind. Die Verbundfolie kann auch nur Funktionselemente aufweisen, die nicht als Funktionsschicht ausgebildet sind. Ein als Funktionsschicht ausgebildetes Funktionselement kann schichtförmig ausgebildet sein.

Der Verbund kann eine Schutzschicht aufweisen, wobei die Funktionselemente und die Leiterbahnen zwischen der Trägerfolie und der Schutzschicht angeordnet sind. Die Schutzschicht bildet die andere Außenseite der Verbundfolie.

Bei der Schutzschicht kann es sich beispielsweise um eine Lackschicht oder eine Deckfolie, beispielsweise um eine Kunststofffolie handeln. Ist eine Lackschicht vorgesehen, so bildet die Lackschicht einen Schutzlack zum Schutz der Funktionselemente und Leiterbahnen. Die Deckfolie kann auf das oder die äußeren Funktionselemente und/oder die äußere(n) Leiterbahn(en) auflaminiert sein. Die Lacksicht hat vorzugsweise eine Ausdehnung in Dickenrichtung der Verbundfolie von weniger als 1,00 mm, stärker bevorzugt von weniger als 0,5 mm und besonders bevorzugt von weniger als 0,1 mm. Die Deckfolie hat vorzugsweise eine Ausdehnung in Dickenrichtung der Verbundfolie von weniger als 1,00 mm, stärker bevorzugt von weniger als 0,5 mm und besonders bevorzugt von weniger als 0,1 mm. Unter einem äußeren Funktionselement wird ein Funktionselement verstanden, das mit seiner ersten Flächenseite auf der Trägerfolie, einem anderen Funktionselement, einer Isolierschicht oder einer Leiterbahn aufliegt, dessen andere Flächenseite aber nicht oder nicht vollständig von einem anderen Funktionselement, einer Isolierschicht oder einer Leiterbahn bedeckt ist. Unter einer äußeren Leiterbahn wird eine Leiterbahn verstanden, die mit ihrer ersten Flächenseite auf der Trägerfolie, einem Funktionselement, einer Isolierschicht oder einer anderen Leiterbahn aufliegt, dessen andere Flächenseite aber nicht oder nicht vollständig von einem Funktionselement, einer Isolierschicht oder einer anderen Leiterbahn bedeckt ist.

Die Schutzschicht hat in Flächenrichtung vorzugsweise die gleiche Ausdehnung wie die Trägerfolie. Die Schutzschicht und die Trägerfolie können parallel und fluchtend zueinander ausgebildet sein. Ist die erste Flächenseite der Trägerfolie nicht vollständig von dem oder den Funktionselementen und/oder den Leiterbahnen bedeckt, so bedeckt die Schutzschicht auch jene Abschnitte der ersten Flächenseite der Trägerfolie, die nicht von einem Funktionselement oder einer Leiterbahn bedeckt sind.

Alternativ oder zusätzlich zu einer Schutzschicht kann das Formteil mit einem Kunststoffmaterial verbunden sein, so dass die Funktionselemente und Leiterbahnen zwischen der Trägerfolie und dem Kunststoffmaterial angeordnet sind. Das Kunststoffmaterial bildet die andere Außenseite der Verbundfolie. Das Kunststoffmaterial kann beispielsweise mittels Spritzgießens auf das oder die äußeren Funktionselemente und/oder die äußere(n) Leiterbahn(en) aufgebracht sein. Weist die Verbundfolie hingegen eine Schutzschicht auf, kann das Kunststoffmaterial auf die zweite Flächenseite der Trägerfolie und/oder auf die Schutzschicht aufgebracht sein. Das erfindungsgemäße Formteil kann zum Aufbringen des Kunststoffmaterials in eine Spritzgussform eingelegt und mit einem Kunststoffmaterial vor- und/oder hinterspritzt werden. Das erfindungsgemäße Formteil bildet gemeinsam mit dem Kunststoffmaterial ein Spritzgussteil. Bei dem Spritzgussteil kann es sich um die erfindungsgemäße Eingabevorrichtung handeln. Es kann jedoch vorgesehen sein, dass die erfindungsgemäße Eingabevorrichtung neben dem Spritzgussteil weitere Elemente aufweist. Das Kunststoffmaterial kann eine folienartige Schicht bilden, deren Ausdehnung in Dickenrichtung gleich oder kleiner als die Ausdehnung der Trägerfolie in Dickenrichtung sein kann. Vorzugsweise ist die Ausdehnung der folienartigen Schicht aus dem Kunststoffmaterial gleich oder größer als die Ausdehnung der Trägerfolie, bezogen auf deren Flächenausdehnung. Das Kunststoffmaterial kann in gleicher Weise wie die Schutzschicht für einen Dickenausgleich sorgen.

Ein Funktionselement kann mittels additiver Verfahren auf die Trägerfolie, ein oder mehrere andere Funktionselemente, eine Isolationsschicht und/oder eine oder mehrere Leiterbahnen aufgebracht werden. Ein Beispiel eines additiven Verfahrens ist ein Druckverfahren. Ein anderes additives Verfahren, mit dem ein Funktionselement auf die Trägerfolie, ein anderes Funktionselement, eine Isolationsschicht und/oder eine Leiterbahn aufgebracht werden kann, ist das Pick-and-Place-Verfahren. Eine Funktionsschicht wird vorzugsweise aus Schichten aufgebaut, die nacheinander auf die Trägerfolie, ein anderes Funktionselement, eine Isolationsschicht oder eine Leiterbahn aufgebracht werden.

Ebenso können die Leiterbahnen mittels additiver Verfahren auf die Trägerfolie, ein oder mehrere Funktionselemente, eine Isolationsschicht und/oder eine oder mehrere Leiterbahnen aufgebracht werden. Ein Beispiel eines additiven Verfahrens ist ein Druckverfahren. Zum Aufbringen der Leiterbahnen können leitfähige Druckpasten eingesetzt werden. Diese erlauben hohe Umformgrade der Verbundfolie.

Ein Funktionselement kann eine elektrische Komponente sein. Beispiele elektrischer Komponenten umfassen integrierte Schaltungen, Stromanschlüsse (ELT), Batterien, Widerstände, Heizelemente, Kondensatoren und Transistoren, wobei die Aufzählung nicht abschließend ist.

Ein Funktionselement kann eine elektronische Komponente sein. Bei einer elektronischen Komponente kann es sich beispielsweise um einen Aktor, einen Sensor oder ein optoelektronisches Bauelement handeln, wobei die Aufzählung nicht abschließend ist. Beispiele optoelektronischer Bauelemente sind Leuchtdioden (LED) und organische Leuchtdioden (OLED). OLEDs haben eine geringere Dicke als LEDs. Sie sind nur wenige Mikrometer dick, beispielsweise weniger als 500 Mikrometer. Ist eine OLED als Funktionsschicht ausgebildet, so kann sie beispielsweise zwei 100 Mikrometer oder zwei 50 Mikrometer dicke Folien aufweisen, zwischen denen die OLED-Schicht angeordnet ist, deren Dicke im Nanometerbereich liegt. Eine solche OLED ist beispielsweise nur 210 Mikrometer oder weniger bzw. nur 110 Mikrometer oder weniger dick, d. h. extrem flach, weil die OLED-Schicht nur wenige Nano- bis wenige Mikrometer dick ist. Als Funktionsschichten ausgebildete OLEDs ermöglichen es somit, dünne, biegsame, in verschiedenen Farben leuchtende, günstige, energiesparende Leuchtelemente in die Verbundfolie und den aus der Verbundfolie erhaltenen Formkörper zu integrieren. Bei einem Sensor kann es sich beispielsweise um einen berührungsempfindlichen Sensor, einen Temperatursensor, einen Drucksensor oder einen Bewegungssensor handeln.

Eine Funktionsschicht kann mittels eines Druckverfahrens auf der Trägerfolie, einem oder mehreren anderen Funktionselementen, einer Isolationsschicht und/oder einer oder mehreren Leiterbahnen hergestellt werden. Das heißt mit anderen Worten, dass die Funktionsschicht nicht als fertiges Teil auf die Trägerfolie, eines oder mehrere andere Funktionselemente, eine Isolationsschicht und/oder eine oder mehrere Leiterbahnen aufgebracht wird, sondern dort erst entsteht. Beispielsweise können OLEDs hergestellt werden, indem sie schichtweise mittels des Druckverfahrens aufgebaut werden. Auf diese Weise können besonders dünne Funktionselemente erhalten werden, die in der vorliegenden Erfindung als Funktionsschichten bezeichnet werden. Eine solche Funktionsschicht, beispielsweise eine solche OLED, hat vorzugsweise eine Ausdehnung in Dickenrichtung der Verbundfolie von 100 Mikrometer oder weniger, stärker bevorzugt von 50 Mikrometer oder weniger und besonders bevorzugt von 10 Mikrometer oder weniger.

Eine Leiterbahn kann, vorzugsweise in Verbindung mit zumindest einer anderen Leiterbahn, zur Versorgung eines Funktionselementes mit elektrischem Strom und/oder zur Leitung von Daten zu einem Funktionselement oder von dem Funktionselement weg vorgesehen sein. Die Leitung von Daten zu einem Funktionselement und/oder von dem Funktionselement weg wird im Folgenden auch als Datenkommunikation bezeichnet. Die Leiterbahnen können elektrische Schaltungen bilden. Eine Leiterbahn kontaktiert vorzugsweise ein, zwei oder mehr Funktionselemente.

Der Verbund kann eine oder mehrere Isolationsschichten zur elektrischen Isolierung der Funktionsschichten voneinander umfassen. Dazu kann jeweils eine Isolationsschicht zwischen zwei Funktionsschichten angeordnet sein. Durch eine Isolationsschicht können Leiterbahnen geführt sein, um eine Versorgung der Funktionselemente mit elektrischem Strom und/oder Datenkommunikation der Funktionselemente in den verschiedenen Funktionsschichten sicherzustellen. Eine Isolationsschicht kann ebenso zur elektrischen Isolierung von übereinander angeordneten Leiterbahnen und/oder Funktionselementen, beispielsweise zur elektrischen Isolierung von sich überkreuzenden Leiterbahnen, vorgesehen sein. Die Isolationsschicht kann aus demselben Material wie die Deckfolie bestehen. Die Isolationsschicht hat vorzugsweise eine Ausdehnung in Dickenrichtung der Verbundfolie von weniger als 1,00 mm, stärker bevorzugt von weniger als 0,5 mm und besonders bevorzugt von weniger als 0,1 mm.

Der Verbund kann somit aus folgenden Bestandteilen bestehen: (i) einer Trägerfolie, (ii) einer oder mehreren Funktionselementen, von denen ein Teil oder alle als Funktionsschichten ausgebildet sein können, (iii) einer oder mehreren Leiterbahnen, (iv) falls vorgesehen, einer Schutzschicht und (v) falls vorgesehen, einer oder mehreren Isolationsschichten. Ist eine Schutzschicht vorgesehen, so sind das oder die Funktionselemente, die Leiterbahn(en) und, falls vorgesehen, die Isolationsschicht(en) zwischen der Trägerfolie und der Schutzschicht angeordnet. Die Trägerfolie, die Funktionselemente, die Leiterbahnen und, falls vorgesehen, die Isolationsschicht(en) können dabei unter Ausbildung einer Sandwich-Struktur mit ihren Flächenseiten aneinander anliegen.

Ein Beispiel eines Aktors ist ein Piezo-Aktor. Ein Piezo-Aktor kann ein flacher Aktor sein. Die mechanischen Schwingungen, die ein Piezo-Aktor erzeugen kann, können genutzt werden, um haptische Signale, beispielsweise eine Vibration, zu erzeugen. Bei Stromfluss verändert ein Piezo-Aktor sein Volumen, so dass er Vibrationen erzeugen kann. Beispiele von Sensoren sind berührungsempfindliche Sensoren, Taster, Schalter sowie Kombinationen aus Taster und Schalter, wobei die Aufzählung nicht abschließend ist. Ein Beispiel eines berührungsempfindlichen Sensors ist ein Touchsensor. Ein solcher Touchsensor kann ein Touchpad sein. Ein Beispiel einer Batterie ist eine gedruckte, wiederaufladbare Pufferbatterie. Ein Beispiel eines Kondensators ist ein Kondensator zur Pufferung und/oder Speicherung von Energie. Heizelemente sind flächig herstellbar. Soll die erfindungsgemäße Eingabevorrichtung im Außenbereich eingesetzt werden, so können ein oder mehrere Heizelemente zum Frostschutz eingesetzt werden. Das oder die Heizelemente können überdies für eine angenehme Bedienung der erfindungsgemäßen Eingabevorrichtung sorgen, wenn sie zur Erwärmung des Formteils bei niedrigen Temperaturen, beispielsweise bei Temperaturen unter 10 °C eingesetzt werden. Außerdem können das oder die Heizelemente für die Realisierung haptischer Rückmeldung genutzt werden, indem gezielt vom Nutzer wahrnehmbare Temperaturschwankungen an den Außenseiten des Formteils erzeugt werden.

Zumindest eines der Funktionselemente ist ein Eingabemittel. Vorzugsweise weist die erfindungsgemäße Eingabevorrichtung zwei oder mehr als Eingabemittel dienende Funktionselemente auf. Unter einem Eingabemittel wird eine elektrische und/oder elektronische Komponente verstanden, die eine Aktion des Nutzers erfassen kann. Beispielsweise kann es sich bei dem als Eingabemittel dienenden Funktionselement um einen Sensor handeln. Ein Beispiel eines Sensors, der als Eingabemittel dienen kann, ist ein berührungsempfindlicher Sensor. Mittels eines berührungsempfindlichen Sensors kann Berührung des Sensors durch den Nutzer erfasst werden. Dabei können sowohl der Ort der Berührung als auch die Bewegung, die der Nutzer auf dem Sensor ausführt, erfasst werden.

Es ist wesentlich, dass die Verbundfolie das oder die Funktionselemente und die Leiterbahn(en) bereits aufweist, bevor sie zu dem erfindungsgemäßen Formteil umgeformt wird. Das heißt mit anderen Worten, dass die Verbundfolie, bestehend aus der Trägerfolie, einem oder mehreren Funktionselementen, und, falls vorgesehen, der Schutzschicht, dem Umformprozess unterzogen wird. Dazu bestehen die Funktionselemente und die Leiterbahnen aus Materialien, die einer Umformung ohne Beeinträchtigung ihrer Funktion standhalten.

Bei einem Funktionselement handelt es sich vorzugsweise um ein flaches Funktionselement. Unter dem Begriff "flach" wird dabei verstanden, dass die Ausdehnung eines Funktionselementes in Dickenrichtung der Verbundfolie vorzugsweise geringer als 500 Mikrometer, besonders bevorzugt kleiner als 100 Mikrometer ist. Ein Funktionselement mit einer solchen Ausdehnung wird im Folgenden auch als "flaches Funktionselement" bezeichnet. Ist ein Funktionselement als Funktionsschicht ausgebildet, so kann die Ausdehnung der Funktionsschicht in Dickenrichtung der Verbundfolie, wie oben beschrieben, bei 100 Mikrometer oder weniger, stärker bevorzugt bei 50 Mikrometer oder weniger und besonders bevorzugt bei 10 Mikrometer oder weniger liegen. Eine Funktionsschicht ist definitionsgemäß ein flaches Funktionselement. Die Schichten, aus denen die Funktionsschicht aufgebaut ist, können eine Ausdehnung von 1 Mikrometer oder weniger, bevorzugt 0,01 Mikrometer oder weniger haben.

Im Vergleich zu anderen flachen Funktionselementen ist die Ausdehnung einer Batterie in Dickenrichtung am größten, die Ausdehnung eines Sensors in Dickenrichtung hingegen am geringsten. Beispielsweise kann die Ausdehnung eines Sensors zwischen wenigen Nanometern, beispielsweise 20 nm, und einigen Mikrometern, beispielsweise 50 Mikrometer, liegen. Die Verbindung des Formteils mit dem Kunststoffmaterial ist insbesondere dann zweckmäßig, wenn die Verbundfolie ein Funktionselement aufweist, das nicht flach ist. Ein Beispiel eines Funktionselementes, das nicht flach ist, ist eine LED. Ein Funktionselement, das nicht flach ist, kann eine Ausdehnung in Dickenrichtung der Verbundfolie von 1 mm oder mehr aufweisen. Vorzugsweise übersteigt die Ausdehnung in dieser Richtung 5 mm nicht. Ein Funktionselement, das nicht flach ist, wird im Folgenden auch als "nicht-flaches Funktionselement" bezeichnet. Vorzugsweise sind jedoch alle Funktionselemente der erfindungsgemäßen Eingabevorrichtung flache Funktionselemente.

Bei einer Leiterbahn handelt es sich vorzugsweise um eine flache Leiterbahn. Unter dem Begriff "flach" wird dabei verstanden, dass die Ausdehnung der Leiterbahn in Dickenrichtung der Verbundfolie vorzugsweise geringer als 500 Mikrometer, und besonders bevorzugt geringer als 100 Mikrometer ist. Vorzugsweise sind alle Leiterbahnen der erfindungsgemäßen Eingabevorrichtung flache Leiterbahnen. Die Leiterbahnen können Flachleiter sein.

In einer Ausführungsform weist das Formteil Leiterbahnen und zwei oder mehr Funktionselemente auf. Die Funktionselemente sind vorzugsweise elektronische Komponenten, vorzugsweise als Eingabemittel dienende berührungsempfindliche Sensoren. Vorzugsweise sind zusätzlich ein oder mehrere weitere Funktionselemente, bei denen es sich um optoelektronische Bauelemente und/oder Piezo-Aktoren handelt, vorgesehen. Bei den optoelektronischen Bauelementen kann es sich um LEDs oder OLEDs handeln, wobei OLEDs bevorzugt sind. Die berührungsempfindlichen Sensoren sind vorzugsweise Touchsensoren. Die OLEDs und die berührungsempfindlichen Sensoren können sich überlagern und/oder wechselweise angeordnet sein. Sie können übereinander angeordnet sein, beispielsweise in verschiedenen Funktionsschichten. In einem Beispiel ist eine OLED eine zweite Funktionsschicht, die auf einem berührungsempfindlichen Sensor angeordnet ist, der eine erste Funktionsschicht ist, die wiederum auf die Trägerfolie aufgebracht ist. Zusätzlich kann ein weiteres Funktionselement vorgesehen sein, bei dem es sich um eine elektrische Komponente, nämlich um genau einen Stromanschluss, handelt kann.

Die Verbundfolie hat, bevor sie der Umformung unterzogen wird, vorzugsweise eine Ausdehnung in ihrer Dickenrichtung von 2 mm oder weniger, vorzugsweise von 1 mm oder weniger. Das gilt insbesondere dann, wenn sie nur flache Funktionselemente aufweist. Die Verbundfolie hat vorzugsweise eine konstante Dicke. Weist der Verbund eine Schutzschicht auf, so kann die Schutzschicht, falls erforderlich, einen Dickenausgleich bewirken. Die mittels Laminierung auf die äußeren Funktionselemente und/oder äußeren Leiterbahnen aufgetragene Schutzschicht kann sich durch Verformung an die innere Geometrie der äußeren Funktionselemente und/oder der äußeren Leiterbahnen anpassen, während die äußere Geometrie der Schutzschicht unter Einwirkung der Laminierwerkzeuge, beispielsweise Laminierwalzen oder Laminierplatten, für eine flache äußere Oberfläche der Schutzschicht und damit ein konstante Dicke des Verbundes sorget.

Zur Kontaktierung der Funktionselemente und/oder Leiterbahnen können Kontaktelemente vorgesehen sein. Die Kontaktelemente können einen Stromanschluss bilden. Die Kontaktierung kann über die zweite Flächenseite der Trägerfolie erfolgen. Die Kontaktierung kann beispielsweise mittels Durchkontaktierung oder unter Freilegung der Trägerfolie bis zu den Leiterbahnen oder bis zu den Kontakten der jeweiligen elektrischen oder elektronischen Komponente erfolgen. Die Freilegung der Trägerfolie bis zu den Kontakten kann beispielsweise mittels Laser durchgeführt werden. Der Formkörper kann somit Kontaktelemente aufweisen, die eine Versorgung einer oder mehrerer Funktionselemente mit elektrischem Strom oder die Datenkommunikation mit den Funktionselementen ermöglichen. Die Kontaktelemente können durch die Trägerfolie geführt sein. Es ist nicht erforderlich, dass jedes der Funktionselemente mittels der durch die Trägerfolie geführten elektrischen Leiter direkt kontaktiert wird. Es kann ausreichend sein, die Leiterbahnen des Formteils zu kontaktieren, was als indirekte Kontaktierung bezeichnet wird. Es ist jedoch auch eine Kombination aus direkter und indirekter Kontaktierung möglich.

Das dreidimensionale Formteil der erfindungsgemäßen Eingabevorrichtung kann einen Hohlraum mit einer Decke aufweisen, die eine erste elektronische Komponente aufweist. Der Hohlraum kann ferner einen an die Decke angrenzenden Mantel, der eine oder mehrere zweite elektronische Komponenten aufweist, besitzen. Die erste elektronische Komponente und die zweite(n) elektronische(n) Komponente(n) sind Funktionselemente, vorzugsweise flache Funktionselemente, besonders bevorzugt Funktionsschichten. Es kann vorgesehen sein, dass die zweiten elektronischen Komponenten, die der Mantel aufweist, mittels einer oder mehreren Leiterbahnen mit der ersten elektronischen Komponente verbunden sind.

Der Formkörper kann eine Basis aufweisen, die an den Mantel angrenzt. Dabei erstreckt sich die Basis vorzugsweise von dem Hohlraum weg. Es können eine oder mehrere Leiterbahnen vorgesehen sein, die sich von den zweiten elektronischen Komponenten in die Basis erstrecken. Die Basis kann eine oder mehrere dritte elektronische Komponenten aufweisen. Die dritte(n) elektronische(n) Komponente(n) sind vorzugsweise flache Funktionselemente, besonders bevorzugt Funktionsschichten. Es kann vorgesehen sein, dass die dritten elektronischen Komponenten, die die Basis aufweist, mittels einer oder mehreren Leiterbahnen mit den zweiten elektronischen Komponenten verbunden sind.

Vorzugsweise sind die ersten, zweiten und dritten elektronischen Komponenten sowie die Leiterbahnen auf der ersten Flächenseite der Trägerfolie angeordnet, während die zweite Flächenseite der Trägerfolie dem Hohlraum zugewandt ist. Die erfindungsgemäße Eingabevorrichtung kann eine Schutzschicht aufweisen, die die ersten, zweiten und dritten elektronischen Komponenten, die Leiterbahnen und - falls die ersten, zweiten und dritten elektronischen Komponenten und die Leiterbahnen die erste Flächenseite der Trägerfolie nicht vollständig abdecken - auch die nicht von diesen Komponenten abgedeckten Abschnitte der Trägerfolie bedeckt. Die Ausdehnung der Schutzschicht in Flächenrichtung ist vorzugsweise gleich oder kleiner als die Ausdehnung der Trägerfolie in Flächenrichtung. Die Schutzschicht ist vorzugsweise parallel und fluchtend zur Trägerfolie angeordnet.

Der Hohlraum kann einen kreisförmigen Querschnitt aufweisen. Er kann eine erste Stirnseite aufweisen, die von der Decke verschlossen ist. Er kann eine zweite Stirnseite aufweisen, die offen ist und an der die Basis ausgebildet ist, die sich von dem Hohlraum weg erstreckt. Der Hohlraum kann über seine gesamte Ausdehnung zwischen der ersten und der zweiten Stirnseite einen konstanten Durchmesser haben. Es kann jedoch auch vorgesehen sein, dass der Hohlraum einen ersten Abschnitt und einen zweiten Abschnitt aufweist, wobei sich der erste Abschnitt von der ersten Stirnseite bis zum zweiten Abschnitt und sich der zweite Abschnitt vom ersten Abschnitt bis zur zweiten Stirnseite erstreckt. Dabei kann der erste Abschnitt eine kegelstumpfförmige Grundform aufweisen, so dass sich sein Querschnitt von der ersten Stirnseite zum zweiten Abschnitt hin vergrößert. Der zweite Abschnitt kann eine kreiszylinderförmige Grundform aufweisen.

Bei der ersten elektronischen Komponente, die die Decke aufweist, kann es sich um einen berührungsempfindlichen Sensor handeln, der als Eingabemittel dient. Bei der oder den zweiten elektronischen Komponenten, die der Mantel aufweist, kann es sich um berührungsempfindliche Sensoren handeln, die ebenfalls als Eingabemittel dienen. Es kann jedoch vorgesehen sein, dass der Teil des Mantels, der den ersten Abschnitt begrenzt, ein oder mehrere optoelektronische Bauelemente, und der Teil des Mantels, der den zweiten Abschnitt begrenzt, berührungsempfindliche Sensoren, die als Eingabemittel dienen, aufweist. Bei der oder den dritten elektronischen Komponenten, die die Basis aufweist, kann es sich um optoelektronische Bauelemente handeln. Mittels der Leiterbahnen können die ersten, zweiten und dritten elektronischen Komponenten mit elektrischem Strom versorgt und/oder eine Datenkommunikation mit dem elektronischen Gerät, das mittels der erfindungsgemäßen Eingabevorrichtung gesteuert werden soll, ermöglicht werden.

Weist der Mantel berührungsempfindliche Sensoren auf, so können die berührungsempfindlichen Sensoren in Umfangsrichtung des Mantels voneinander beabstandet in dem Mantel angeordnet sein. Weist der Mantel berührungsempfindliche Sensoren auf, so können die berührungsempfindlichen Sensoren streifenförmig ausgebildet sein. Die streifenförmigen berührungsempfindlichen Sensoren sind dabei vorzugsweise so in dem Mantel angeordnet, dass ihre Längsachse quer zur Umfangsrichtung des Mantels verläuft.

Die beabstandete Anordnung der berührungsempfindlichen Sensoren in Umfangsrichtung des Mantels ermöglicht eine einfache Detektierung einer Bewegung eines Nutzers, dessen Hand auf der Eingabevorrichtung liegt. Beispielsweise ist eine leicht streichende Drehbewegung, die ein Nutzer ausführt - ohne mechanisch etwas zu bewegen - ausreichend, um diese mittels der berührungsempfindlichen Sensoren zu detektieren. Die Bewegung wird von den berührungsempfindlichen Sensoren erfasst, wobei Daten in den berührungsempfindlichen Sensoren erhalten werden. Die Daten können dann von der Eingabevorrichtung an das elektronische Gerät übertragen und dort von einer Software unter Erhalt von Steuerungsdaten ausgewertet werden. Mit den Steuerungsdaten kann eine Steuerung des elektronischen Gerätes bewirkt werden.

Der in der Decke angeordnete berührungsempfindliche Sensor kann beispielsweise zur Eingabe von Informationen, beispielsweise von Buchstaben und/oder Zahlen, durch den Nutzer eingesetzt werden. Diese Informationen können dann von der Eingabevorrichtung an das elektronische Gerät übertragen und dort von einer Software unter Erhalt von Steuerungsdaten ausgewertet werden. Mit den Steuerungsdaten kann eine Steuerung des elektronischen Gerätes bewirkt werden.

Bei den berührungsempfindlichen Sensoren der erfindungsgemäßen Eingabevorrichtung handelt es sich vorzugsweise um Touchsensoren. Bei den optoelektronischen Bauelementen handelt es sich vorzugsweise um LEDs oder OLEDs. Sollen die Funktionselemente flache Funktionselemente sein, so sind die optoelektronischen Bauelementen vorzugsweise OLEDs.

Die erfindungsgemäße Eingabevorrichtung zur Steuerung eines elektronischen Gerätes weist eine geringere Anzahl von Bauelementen auf. Sie ermöglicht eine leichte, sichere und schnelle Steuerung eines elektronischen Gerätes, beispielsweise eines Rechnersystems eines Fahrzeuges.

Die erfindungsgemäße Eingabevorrichtung ist insbesondere zur Steuerung von Rechnersystemen, beispielsweise zur Steuerung von Rechnersystemen von Fahrzeugen geeignet. Bei dem Rechnersystem eines Fahrzeuges kann es sich insbesondere um ein Infotainmentsystem handeln. Ein solches Infotainmentsystem kann eine oder mehrere Komponenten aufweisen. Beispielsweise kann das Infotainmentsystem eine oder mehrere der folgenden Komponenten aufweisen: Kommunikationssystem, Navigationssystem, Audiosystem, Videosystem, Audio-/Videosystem, Fahrerassistenzsystem. Das Rechnersystem weist eine Anzeigeeinheit auf, auf der Funktionen, beispielsweise in Form von Tasten oder Menüs dargestellt sind. Mittels der erfindungsgemäßen Eingabevorrichtung kann ein Nutzer die auf der Anzeigeeinheit dargestellten Funktionen leicht und sicher auswählen. Die erfindungsgemäße Eingabevorrichtung ist jedoch nicht auf die Auswahl der auf der Anzeigeeinheit dargestellten Funktionen beschränkt. Vielmehr kann die erfindungsgemäße Eingabevorrichtung auch verwendet werden, um andere Funktionen, die keine graphische Darstellung erfordern, zu steuern. Die erfindungsgemäße Eingabevorrichtung kann an der Mittelkonsole eines Fahrzeuges angeordnet oder Bestandteil einer solchen Mittelkonsole sein.

Nach Maßgabe der Erfindung ist ferner ein Verfahren zur Herstellung einer erfindungsgemäßen Eingabevorrichtung vorgesehen, das die Schritte umfasst:
(a) Bereitstellen einer Kunststoff-Trägerfolie,
(b) Herstellen einer Verbundfolie, wobei das Herstellen der Verbundfolie das Aufbringen eines oder mehrerer Funktionselemente und/oder einer oder mehrerer Leiterbahnen auf die Trägerfolie umfasst; und
(c) Umformen der Verbundfolie zu einem Formteil.

Zum Bereitstellen der Trägerfolie in Schritt (a) kann vorgesehen sein, dass die Trägerfolie als Rolle bereitgestellt wird. Sie kann von der Rolle abgewickelt werden und dabei beispielsweise in eine Lage gebracht werden, bei der ihre erste Flächenseite in einer Ebene liegt.

In Schritt (b) können eine oder mehrere Funktionselemente und/oder eine oder mehrere Leiterbahnen auf die erste Flächenseite der Trägerfolie aufgebracht werden. Die Funktionselemente und/oder Leiterbahnen liegen unmittelbar auf der Flächenseite der Trägerfolie auf. Anschließend können auf die unmittelbar aufliegenden Funktionselemente und/oder Leiterbahnen weitere Funktionselemente und/oder Leiterbahnen aufgebracht werden. Auf die äußeren Funktionselemente und/oder Leiterbahnen kann eine Schutzschicht aufgebracht werden. Das Aufbringen einer Schutzschicht ist jedoch insbesondere dann nicht erforderlich, wenn das in Schritt (c) erhaltene Formteil anschließend mit einem Kunststoffmaterial, beispielsweise durch ein Spritzgussverfahren, verbunden wird. Das Aufbringen des oder der Funktionselemente und/oder der Leiterbahnen(en) erfolgt unter der Maßgabe, dass die Verbundfolie zumindest eine Leiterbahn und zumindest ein Funktionselement aufweist.

Es ist wesentlich, dass die Verbundfolie in Schritt (c) der Umformung unterzogen wird. Die Funktionselemente und Leiterbahnen werden somit nicht nachträglich auf den Formkörper aufgebracht, sondern werden gemeinsam mit der Trägerfolie und, falls vorgesehen, der Schutzschicht, dem Umformen in Schritt (c) unterzogen. Dabei wird die Verbundfolie vorzugsweise mit hohen Umformgraden umgeformt. Das Umformen kann beispielsweise mittels thermischer Umformverfahren erfolgen. Bei einem thermischen Umformverfahren kann ein Heizer eingesetzt werden, der eine gesteuerte Verformung der Verbundfolie ermöglicht. Nach dem Erwärmen der Verbundfolie kann die Umformung durch Einwirkung geeignet gestalteter Formelemente und/oder durch Anwendung von Über- oder Unterdruck erfolgen.

Es kann vorgesehen sein, dass die Trägerfolie in Schritt (a) so bereitgestellt wird, dass ihre erste Flächenseite in einer Ebene liegt. Dabei kann es sich um eine horizontale Ebene handeln. Die erste Flächenseite der Trägerfolie bildet somit eine ebene Fläche, auf die im folgenden Schritt (b) dann ein oder mehrere Funktionselemente und/oder eine oder mehrere Leiterbahnen aufgebracht werden können. Das oder die Funktionselemente und die Leiterbahn(en) können durch ein additives Verfahren, beispielsweise durch Drucken, aufgebracht werden. Die Schutzschicht kann beispielsweise in Form eines Schutzlackes aufgebracht oder in Form einer Folie auflaminiert werden. Auch in Schritt (b) verbleibt die erste Flächenseite der Trägerfolie in einer Ebene. Sie wird beim Aufbringen des oder der Funktionselemente und, falls vorgesehen, der Schutzschicht nicht verformt.

Sollen Funktionselemente und/oder Leiterbahnen übereinander angeordnet werden, so können Isolationsschichten auf die Funktionselemente und/oder Leiterbahnen aufgebracht werden, die bereits aufgebracht worden sind, so dass die weiteren Funktionselemente und/oder Leiterbahnen auf eine Isolationsschicht aufgebracht werden können.

Das erfindungsgemäße Verfahren ermöglicht die Herstellung eines Formteils, bei dem es nicht erforderlich ist, nachträglich elektrische oder elektronische Komponenten auf das in Schritt (c) erhaltene Formteil aufzubringen, auch wenn das möglich ist. Die Funktionalität des erfindungsgemäßen Formteils wird in einer Ebene erzeugt, nämlich durch das Aufbringen des oder der Funktionselemente und der Leiterbahn(en) auf die erste Flächenseite der Trägerfolie, eine oder mehrere andere Funktionselemente, eine Isolationsschicht und/oder eine oder mehrere andere Leiterbahnen. Erst nach dem Erzeugen der Funktionalität findet die Umformung der Verbundfolie zu einem Formkörper statt, d. h. die Trägerfolie wird gemeinsam mit dem oder den Funktionselementen, der oder den Leiterbahnen und, falls vorgesehen, der Schutzschicht dem Umformen unterzogen.

Weist das Formteil eine Schutzschicht auf, so kann es nach dem Umformen in Schritt (c) fertiggestellt sein. Schritt (c) kann somit der letzte Schritt zur Herstellung des erfindungsgemäßen Formteils sein. Das dabei erhaltene Formteil ist eine Ausführungsform einer erfindungsgemäßen Eingabevorrichtung und damit unmittelbar einsatzbereit. Es ist darüberhinaus robust, wasserdicht und aufgrund seiner Oberflächenbeschaffenheit hygienisch.

Es kann vorgesehen sein, dass der in Schritt (c) erhaltene Formkörper mit einem Kunststoffmaterial verbunden wird. Das ist insbesondere dann zweckmäßig, wenn die in Schritt (b) erhaltene Verbundfolie keine Schutzschicht aufweist. Das Kunststoffmaterial kann beispielsweise mittels Spritzgießens auf die äußeren Funktionselemente und/oder Leiterbahnen aufgebracht werden. Weist die Verbundfolie hingegen eine Schutzschicht auf, kann das Kunststoffmaterial auf die zweite Flächenseite der Trägerfolie und/oder die Schutzschicht aufgebracht werden. Zum Verbinden mit einem Kunststoffmaterial kann das in Schritt (c) erhaltene Formteil in eine Spritzgussform eingelegt und mit dem Kunststoffmaterial vor- und/oder hinterspritzt werden. Dabei wird ein Spritzgussteil erhalten. Das erfindungsgemäße Formteil kann somit die Ausgangsbasis für ein Spritzgussteil sein. Ein solches Spritzgussteil wird im Folgenden auch als "funktionalisiertes Spritzgussteil" bezeichnet, weil ihm das oder die Funktionselemente des erfindungsgemäßen Formteils eine Funktionalität verleihen. Das Spritzgussteil ist eine Ausführungsform der erfindungsgemäßen Eingabevorrichtung.

Die Herstellung eines Spritzgussteils aus dem Formteil ermöglicht insbesondere die Herstellung von funktionalisierten Spritzgussteilen in großen Stückzahlen. Die Herstellung ist ein einfacher und sehr kostengünstiger Vorgang. Der Spritzguss verleiht dem Formteil noch mehr Stabilität. Außerdem können gestalterische Elemente berücksichtigt werden. Beispielsweise kann das funktionalisierte Spritzgussteil eine Farbgebung oder visuelle Effekte aufweisen. In einem Beispiel eines visuellen Effektes verdeckt eine mittels Spritzgießens erhaltene Milchglasoberfläche aus einem Kunststoffmaterial eine oder mehrere Funktionselemente, bei denen es sich um optoelektronische Komponenten handelt. Diese optoelektronische(n) Komponente(n) sind dann nur zu sehen, wenn sie aktiv sind.

Die Herstellung eines Spritzgussteiles ist insbesondere dann vorteilhaft, wenn das Formteil ein nicht-flaches Funktionselement aufweist. Ein nicht-flaches Funktionselement kann mittels des Spritzgussverfahrens umspritzt werden. Auch ein solches Spritzgussteil ist vorteilhaft, weil das Aufbringen eines nicht-flachen Funktionselementes auf die erste Flächenseite der Trägerfolie, auf eine oder mehrere flache Funktionselemente, eine Isolationsschicht und/oder eine oder mehrere Leiterbahnen erfolgen kann. Die erste Flächenseite und die flachen Funktionselementen und Leiterbahnen können jeweils eine ebene Fläche bilden. Es ist deutlich einfacher, ein Funktionselement auf eine ebene Fläche als auf das erfindungsgemäße dreidimensionale Formteil aufzubringen. Die Verbundfolie bildet somit vor ihrer Umformung selbst dann, wenn sie ein nicht-flaches Funktionselement aufweist, einen einfach herzustellenden Träger für elektrische und elektronische Komponenten, die nicht flach sind.

Weitere Einzelheiten des erfindungsgemäßen Verfahrens sind vorstehend bereits im Zusammenhang mit dem erfindungsgemäßen Formteil erläutert worden. Auf diese Erläuterung wird zur Vermeidung von Wiederholungen verwiesen.

Die erfindungsgemäße Eingabevorrichtung und das erfindungsgemäße Verfahren bieten eine Vielzahl von Vorteilen. Die erfindungsgemäße Eingabevorrichtung ist wasserdicht, hygienisch optimal, da sie gut reinigbar ist, robust und insbesondere auch für den Einsatz im Außenbereich geeignet. Die erfindungsgemäße Eingabevorrichtung kann daher in einer Vielzahl von Branchen, beispielsweise in der Chemie, der Pharmazie, der Medizintechnik, der Bahntechnik verwendet werden, wobei die Aufzählung nicht abschließend ist. In der Bahntechnik kann das Formteil insbesondere im Zusammenhang mit Fahrkartenautomaten, Parkscheinautomaten, Informationsterminals und vielem anderen mehr eingesetzt werden. Informationsterminals können auch in anderen Brachen eingesetzt werden. Zur Herstellung der erfindungsgemäßen Eingabevorrichtung werden nur wenige Bauteile benötigt.

Die Erfindung wird nachstehend anhand von Ausführungsbeispielen, die die Erfindung nicht einschränken sollen, unter Bezugnahme auf die Zeichnungen näher erläutert. Dabei zeigen
- Fig. 1: eine schematische Darstellung einer Trägerfolie (Fig. 1a: Draufsicht; Fig. 1b: Schnittdarstellung entlang Schnittebene A--A von Fig. 1a);
- Fig. 2: eine schematische Darstellung einer Trägerfolie, auf die mehrere Funktionselemente aufgebacht sind (Fig. 2a: Draufsicht; Fig. 2b: Schnittdarstellung entlang Schnittebene B--B von Fig. 2a);
- Fig. 3: eine schematische Darstellung einer Verbundfolie vor dem Umformen (Fig. 3a: Draufsicht; Fig. 3b: Schnittdarstellung entlang Schnittebene C--C von Fig. 3a);
- Fig. 4: eine schematische Darstellung einer ersten Ausführungsform einer erfindungsgemäßen Eingabevorrichtung (Fig. 4a: Draufsicht; Fig. 4b: Schnittdarstellung entlang Schnittebene D--D von Fig. 4a);
- Fig. 5: eine schematische Darstellung einer anderen Verbundfolie vor dem Umformen (Fig. 5a: Draufsicht; Fig. 5b: Schnittdarstellung entlang Schnittebene E--E von Fig. 5a);
- Fig. 6: eine schematische Darstellung einer zweiten Ausführungsform einer erfindungsgemäßen Eingabevorrichtung (Fig. 6a: Draufsicht; Fig. 6b: Schnittdarstellung entlang Schnittebene F--F von Fig. 6a);
- Fig. 7: eine schematische Darstellung einer dritten Ausführungsform einer erfindungsgemäßen Eingabevorrichtung (Fig. 7a: Draufsicht; Fig. 7b: Schnittdarstellung entlang Schnittebene G--G von Fig. 7a);
- Fig. 8: eine schematische Darstellung einer vierten Ausführungsform einer erfindungsgemäßen Eingabevorrichtung (Fig. 8a: Seitenansicht; Fig. 8b: Ansicht von unten; Fig. 8c Schnittdarstellung entlang Schnittebene H--H von Fig. 8b);
- Fig. 9: eine perspektivische Darstellung einer fünften Ausführungsform einer erfindungsgemäßen Eingabevorrichtung;
- Fig. 10: eine schematische Schnittdarstellung einer sechsten Ausführungsform erfindungsgemäßen Eingabevorrichtung;
- Fig. 11: eine schematische Schnittdarstellung des Formteils der ersten bis sechsten Ausführungsform der erfindungsgemäßen Eingabevorrichtung zur Veranschaulichung des hohen Umformgrades;
- Fig. 12: eine schematische Schnittdarstellung eines anderen Formteils;
- Fig. 13: eine schematische Schnittdarstellung eines noch anderen Formteils; und
- Fig. 14: eine perspektivische Darstellungen einer siebenten Ausführungsform (Fig. 14a: schematische Schnittdarstellung des Formteils dieser Ausführungsform; Fig. 14b: Ansicht von vorn; Fig. 14c: Seitenansicht; Fig. 14d: Ansicht von hinten).

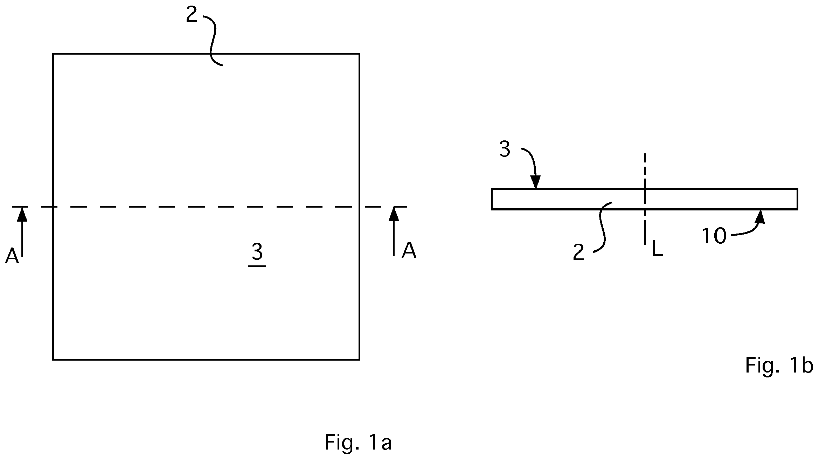

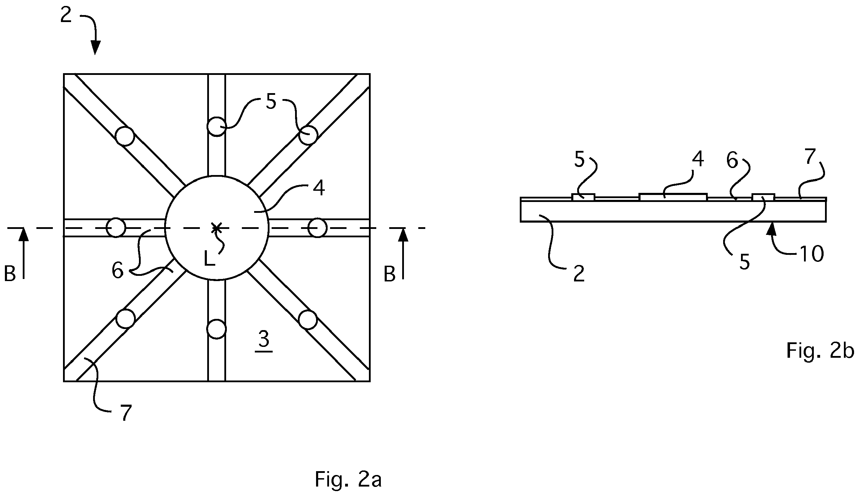

Die Figuren 1 bis 4 veranschaulichen die Herstellung einer ersten Ausführungsform einer erfindungsgemäßen Eingabevorrichtung 1. In einem ersten Schritt, der Schritt (a) des erfindungsgemäßen Verfahrens entspricht, wird eine Trägerfolie 2 bereitgestellt (Figuren 1a und 1b). In diesem Beispiel weist die Trägerfolie 2 eine quadratische erste Flächenseite 3 und eine ihr gegenüberliegende zweite Flächenseite 10 auf. Die erste Flächenseite 3 liegt in einer Ebene, die der Papierebene in Fig. 1a entspricht. Auf die erste Flächenseite 3 werden im nächsten Schritt, der Schritt (b) des erfindungsgemäßen Verfahrens entspricht, Funktionselemente 4, 5 und Leiterbahnen 6, 7 aufgebracht (Figuren 2a und 2b). Bei den Funktionselementen 4, 5 handelt sich um
- einen ersten berührungsempfindlichen Sensor 4, der in der geometrischen Mitte der Flächenseite 3 (Achse L) angeordnet ist; und
- acht erste OLEDs 5, die beabstandet von dem berührungsempfindlichen Sensor 4 einerseits und dem Rand der Flächenseite 3 anderseits, angeordnet sind.

Bei den Leiterbahnen 6, 7 handelt es sich um
- acht erste Leiterbahnen 6, die sich von dem ersten berührungsempfindlichen Sensor 4 jeweils zu einer OLED 5 erstrecken; und
- acht zweite Leiterbahnen 7, die sich jeweils von einer OLED 5 zum Rand der Flächenseite 3 erstrecken.

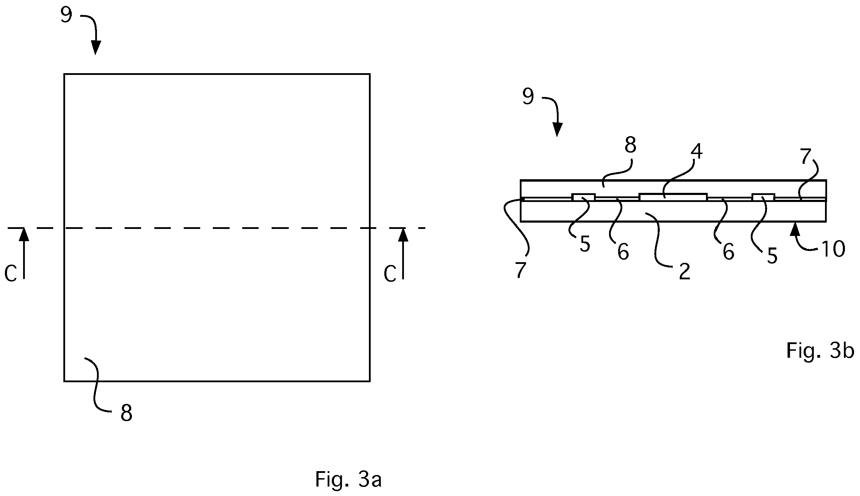

Die Funktionselemente 4, 5, sind flache Funktionselemente, die Leiterbahnen 6, 7 sind flache Leiterbahnen. Die Funktionselemente 4, 5 sind jeweils als Funktionsschichten ausgebildet. Auf die Funktionselemente 4, 5 und die Leiterbahnen 6, 7 wird im nächsten Schritt unter Erhalt einer Verbundfolie 9 eine Schutzschicht 8 aufgebracht, die die Funktionselemente 4, 5 und die Leiterbahnen 6, 7 und die nicht von diesen Funktionselementen 4, 5 und den Leiterbahnen 6, 7 bedeckten Abschnitte der Trägerfolie 2 vollständig bedeckt (Figuren 3a und 3b). Die Ausdehnung der Schutzschicht 8 entspricht der Ausdehnung der Trägerfolie 2, jeweils in Flächenrichtung. Die Schutzschicht 8 ist fluchtend zu der Trägerfolie 2 angeordnet. Die Verbundfolie 9 besteht nun aus der Trägerfolie 2, den Funktionselementen 4, 5, den Leiterbahnen 6, 7 und der Schutzschicht 8, wobei die Funktionselemente 4, 5 und die Leiterbahnen 6, 7 zwischen der Trägerfolie 2 und der Schichtschicht 8 angeordnet sind.

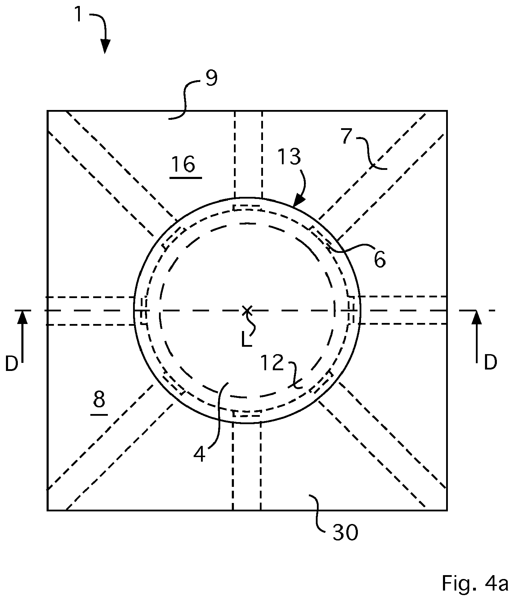

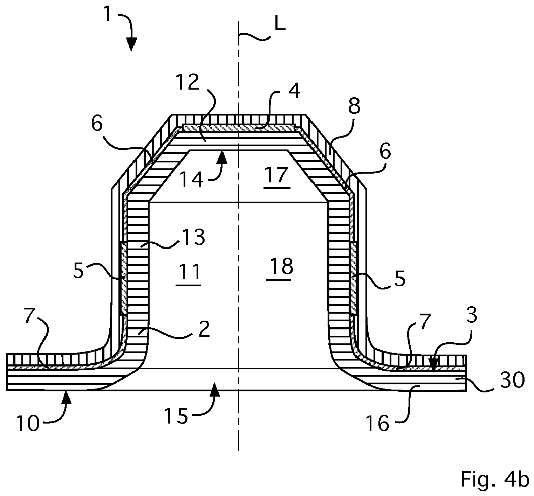

Es ist in den Figuren 3a und 3b zu erkennen, dass die Trägerfolie 2 der Verbundfolie 9 noch immer mit ihrer ersten Flächenseite 3 in einer Ebene liegt. Bei der Herstellung der Verbundfolie 9 wird die Trägerfolie 2 nicht verformt. Die Verbundfolie 9 ist somit flach. Im nächsten Schritt, der Schritt (c) des erfindungsgemäßen Verfahrens entspricht, wird die Verbundfolie 9 nun umgeformt, wodurch ein Formteil (30) erhalten wird. Das Formteil 30 ist eine erste Ausführungsform einer erfindungsgemäßen Eingabevorrichtung 1 (siehe Figuren 4a und 4b). Die Eingabevorrichtung 1 kann weitere Elemente aufweisen, beispielsweise Kontaktelemente. Die Kontaktelemente können eine Kontaktierung der zweiten Leiterbahnen 7 und damit eine Versorgung der Funktionselemente 4, 5 und der ersten und zweiten Leiterbahnen 6, 7 mit elektrischem Strom sowie eine Datenkommunikation mit einem oder mehrere der Funktionselemente 4, 5, insbesondere mit dem berührungsempfindlichen Sensor 4, ermöglichen.

Mittels des Umformens wird aus der flachen Verbundfolie 9 ein Formteil 30 erhalten, das einen Hohlraum 11 aufweist, der von der Decke 12 und einem Mantel 13 begrenzt wird. Der Hohlraum 11 weist einen kreisförmigen Querschnitt auf. Er besitzt eine erste Stirnseite 14, die von der Decke 12 verschlossen ist. Er besitzt ferner eine zweite Stirnseite 15, die offen ist und an der eine Basis 16 ausgebildet ist, die sich von dem Hohlraum 11 weg erstreckt. Der Hohlraum 11 weist einen ersten Abschnitt 17 und einen zweiten Abschnitt 18 auf, wobei, bezogen auf die Längsachse L des Formteils 30, sich der erste Abschnitt 17 von der ersten Stirnseite 14 bis zum zweiten Abschnitt 18 und der zweite Abschnitt 18 sich vom ersten Abschnitt 17 bis zur zweiten Stirnseite 15 erstreckt. Dabei weist der erste Abschnitt 17 eine kegelstumpfförmige Grundform auf, so dass sich sein Querschnitt von der ersten Stirnseite 14 zum zweiten Abschnitt 18 hin vergrößert. Der zweite Abschnitt 18 weist eine kreiszylinderförmige Grundform auf. Bezogen auf Längsachse L des Hohlraums 11 ist der zweite Abschnitt 18 länger als der erste Abschnitt 17. Der Hohlraum kann wenigstens 4 cm, bevorzugt wenigstens 5 cm hoch sein und an der zweiten Stirnseite einen Durchmesser von wenigstens 4 cm, bevorzugt wenigstens 5 cm haben. Es ist insbesondere in Fig. 4b zu erkennen, dass mittels der Umformung ein Formteils 30 erhalten wird, bei dem der berührungsempfindliche Sensor 4 in der Decke 12 angeordnet ist. Die OLEDs 5 sind im Mantel angeordnet sind.

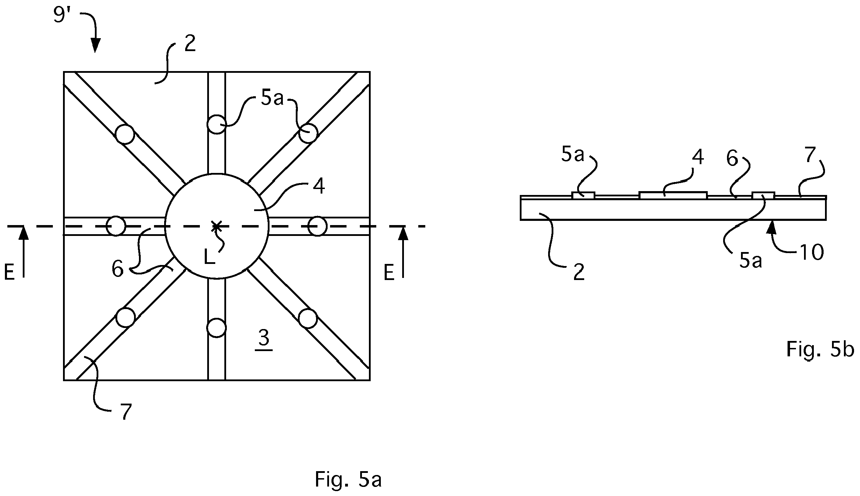

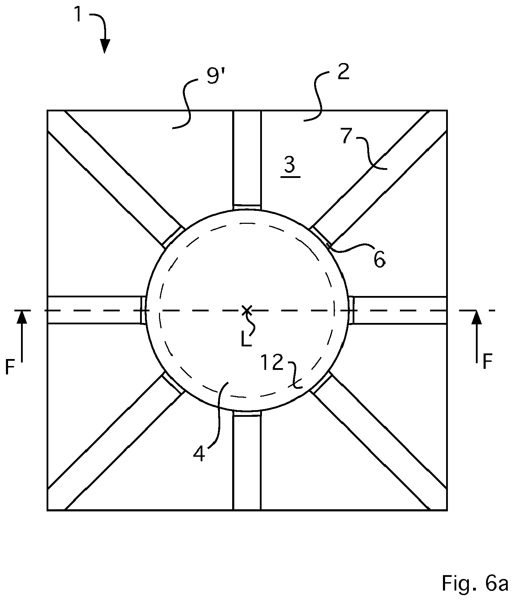

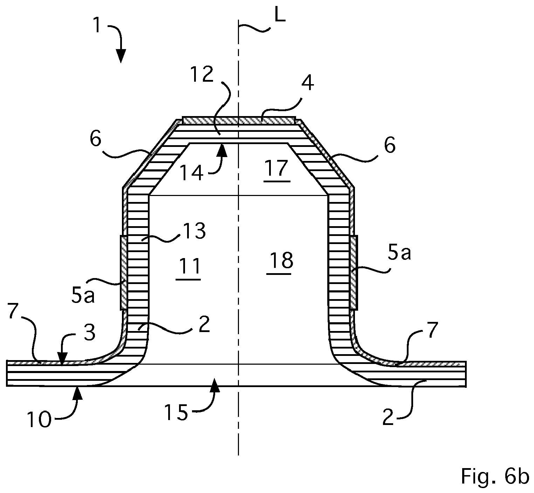

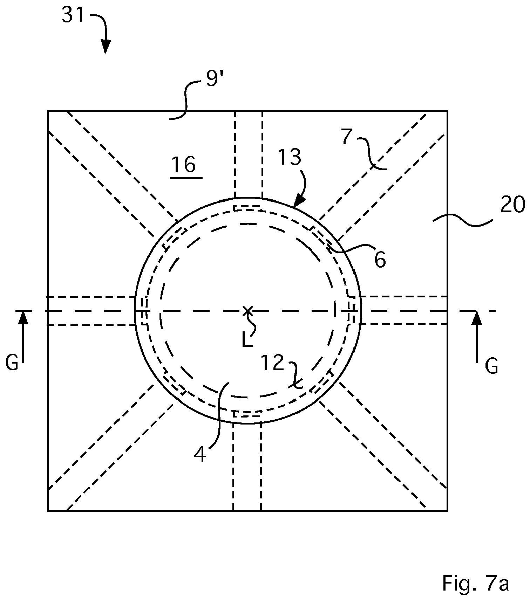

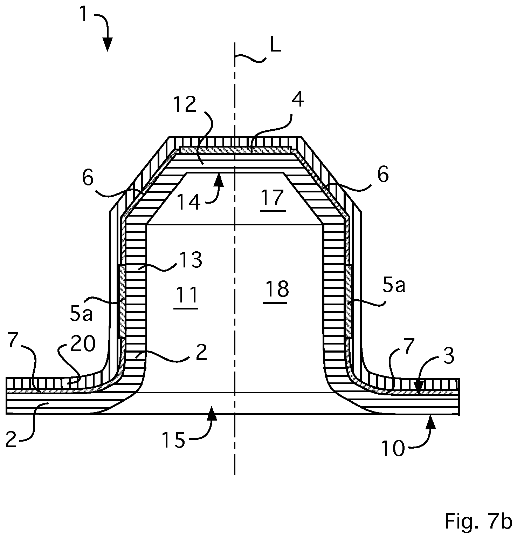

In einer abgewandelten, zweiten Ausführungsform der erfindungsgemäßen Eingabevorrichtung 1 sind anstelle von OLEDs LEDs 5a vorgesehen. Außerdem wird keine Schutzschicht aufgetragen. Stattdessen wird die in den Figuren 5a und 5b gezeigte Verbundfolie 9' umgeformt, um das Formteil 30 zu erhalten (Figuren 6a und 6b). Die Verbundfolie 9' besteht aus der Trägerfolie 2, den Funktionselemente 4, 5a und den Leiterbahnen 6, 7. Die Verbundfolie 9' wird, wie im Zusammenhang mit den Figuren 1a bis 2b beschrieben, erhalten. Nach dem Umformen der Verbundfolie 9' zu einem Formteil 30 wird das Formteil 30 mit einem Kunststoffmaterial 20 verbunden, das mittels Spritzguss unter Ausbildung einer folienartigen Schicht auf die Funktionselemente 4, 5a und die Leiterbahnen 6, 7 aufgebracht wird, wodurch ein Spritzgussteil 31 erhalten wird (Figuren 7a und 7b). Die folienartige Schicht aus dem Kunststoffmaterial 20 bedeckt die Funktionselemente 4, 5a, die Leiterbahnen 6, 7 und die nicht von den Funktionselementen 4, 5 und den Leiterbahnen 6, 7 bedeckten Abschnitte der Trägerfolie 2 vollständig. Die Ausdehnung der folienartigen Schicht aus dem Kunststoffmaterial 20 entspricht der Ausdehnung der Trägerfolie 2, jeweils in Flächenrichtung. Das Spritzgussteil 31 besteht aus dem Formteil 30 und dem Kunststoffmaterial 20. Das Spritzgussteil 31 ist eine dritte Ausführungsform einer erfindungsgemäßen Eingabevorrichtung 1. Die zweite und dritte Ausführungsform der Eingabevorrichtung 1 können weitere Elemente aufweisen, beispielsweise Kontaktelemente. Die Kontaktelemente können eine Kontaktierung der zweiten Leiterbahnen 7 und damit eine Versorgung der Funktionselemente 4, 5, 5a und der ersten und zweiten Leiterbahnen 6, 7 mit elektrischem Strom sowie eine Datenkommunikation mit einem oder mehreren der Funktionselemente 4, 5, 5a, insbesondere mit dem berührungsempfindlichen Sensor 4, ermöglichen.

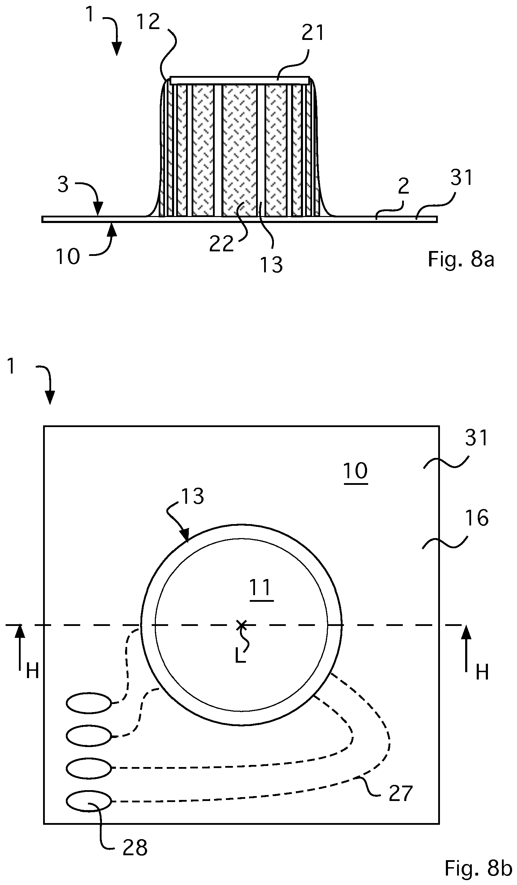

Die Figuren 8a bis 8c veranschaulichen eine vierte Ausführungsform einer erfindungsgemäßen Eingabevorrichtung 1, bei der es sich um ein weiteres Spritzgussteil 31 handelt. Die vierte Ausführungsform der Eingabevorrichtung 1 ist insbesondere zur Steuerung des Rechnersystems eines Kraftfahrzeuges geeignet. Sie kann dazu in der Mittelkonsole eines Kraftfahrzeuges angeordnet sein. Die vierte Ausführungsform der Eingabevorrichtung 1 entspricht der in Fig. 7 gezeigten dritten Ausführungsform, außer dass sie andere Funktionselemente aufweist und die anderen Funktionselemente anders angeordnet sind. In Fig. 8a sind die folienartige Schicht aus einem Kunststoffmaterial 20 und die ersten und zweiten Leiterbahnen 26, 27 zur Vereinfachung der Darstellung nicht gezeigt.

Die in den Figuren 8a bis 8c veranschaulichte vierte Ausführungsform weist folgende Funktionselemente 21, 22 auf:
- einen ersten berührungsempfindlichen Sensor 21, der in der Decke 12 angeordnet ist und kreisförmige Flächenseiten aufweist; und
- zweite berührungsempfindliche Sensoren 22, die im Mantel 13 angeordnet und streifenförmig ausgebildet sind.

Sie weist folgende Leiterbahnen 26, 27 auf:
- erste Leiterbahnen 26, die sich von dem ersten berührungsempfindlichen Sensor 21 jeweils zu einem zweiten berührungsempfindlichen Sensor 22 erstrecken; und
- zweite Leiterbahnen 27, die sich jeweils von einem zweiten berührungsempfindlichen Sensor 22 in die Basis 16 zu dort angeordneten Kontaktelementen 28 erstrecken.

Die zweiten berührungsempfindlichen Sensoren 22 sind streifenförmig ausgebildet und in Umfangsrichtung des Mantels 13 voneinander in dem Mantel 13 beabstandet angeordnet. Die streifenförmigen, zweiten berührungsempfindlichen Sensoren 22 sind dabei so in dem Mantel 13 angeordnet, dass ihre Längsachse quer zur Umfangsrichtung des Mantels 13 verläuft.

Die Kontaktelemente 28 sind im Bereich der Basis 16 durch die Trägerfolie 2 von deren zweiter Flächenseite 10, d. h. von der Unterseite des Formkörpers 1, zu den zweiten Leiterbahnen 27 geführt. Das ermöglicht eine Kontaktierung der zweiten Leiterbahnen 27 und damit eine Versorgung des ersten und der zweiten berührungsempfindlichen Sensoren 21, 22 und der ersten und zweiten Leiterbahnen 26, 27 mit elektrischem Strom sowie eine Datenkommunikation mit dem ersten und den zweiten berührungsempfindlichen Sensoren 21, 22.

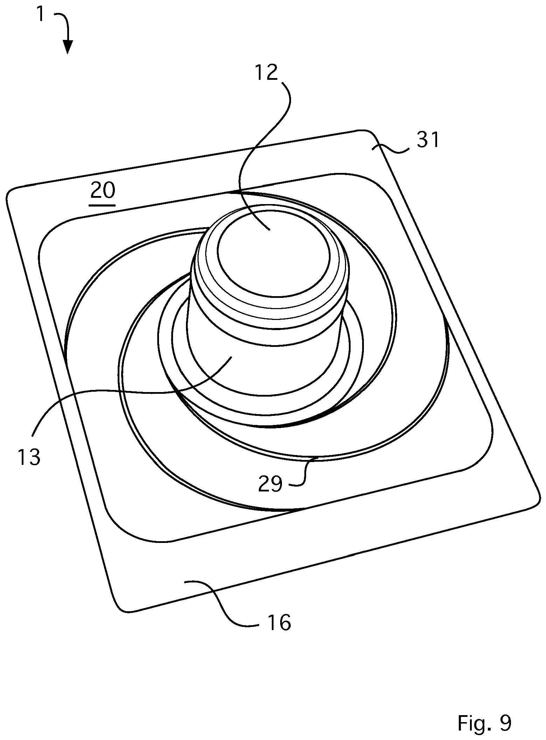

Figur 9 veranschaulicht eine fünfte Ausführungsform einer erfindungsgemäßen Eingabevorrichtung Die fünfte Ausführungsform entspricht der vierten Ausführungsform, außer dass sie zusätzlich gestalterische Elemente 29 aufweist, die in der folienartigen Schicht aus dem Kunststoffmaterial 20 ausgebildet sind.

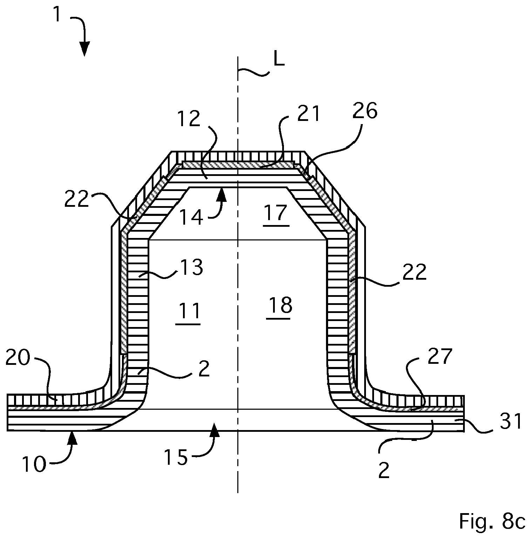

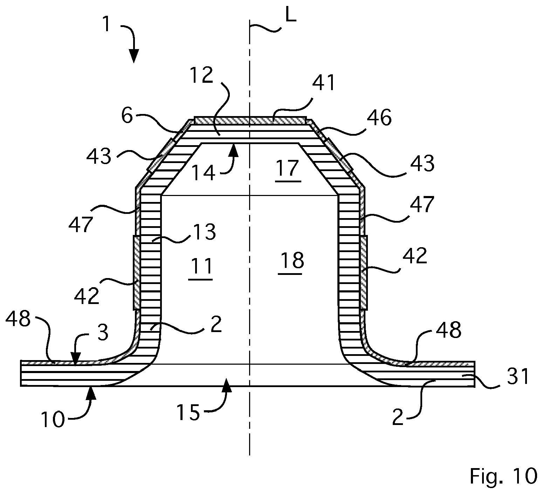

Fig. 10 veranschaulicht eine sechste Ausführungsform einer erfindungsgemäßen Eingabevorrichtung 1. Die sechste Ausführungsform ist insbesondere zur Steuerung des Rechnersystems eines Kraftfahrzeuges geeignet. Sie kann dazu in der Mittelkonsole eines Kraftfahrzeuges angeordnet sein. Die sechste Ausführungsform des Spritzgussteils 31 entspricht der in Fig. 8 gezeigten vierten Ausführungsform, außer dass sie weitere Funktionselemente aufweist und die Funktionselemente anders angeordnet sind.

Die in Fig. 10 gezeigte sechste Ausführungsform des Spritzgussteils 31 weist folgende Funktionselemente auf:
- einen ersten berührungsempfindlichen Sensor 41, der in der Decke 12 angeordnet ist und kreisförmige Flächenseiten aufweist;
- zweite berührungsempfindlichen Sensor 42, die im zweiten Abschnitt des Mantels 13, der den zweiten Abschnitt 18 des Hohlraums 11 begrenzt, angeordnet und streifenförmig ausgebildet sind; und
- OLEDs 43, die im ersten Abschnitt des Mantels 13, der den ersten Abschnitt des Hohlraums 11 begrenzt, angeordnet sind.

Sie weist ferner folgende Leiterbahnen auf:
- erste Leiterbahnen 46, die sich von dem ersten berührungsempfindlichen Sensor 41 jeweils zu einer OLED 43 erstrecken;
- zweite Leiterbahnen 47, die sich jeweils von einer OLED 43 zu einem zweiten berührungsempfindlichen Sensor 42 erstrecken; und
- dritte Leiterbahnen 48, die sich jeweils von einem zweiten berührungsempfindlichen Sensor 42 in die Basis 16 zu dort angeordneten Kontaktelementen 28 erstrecken.

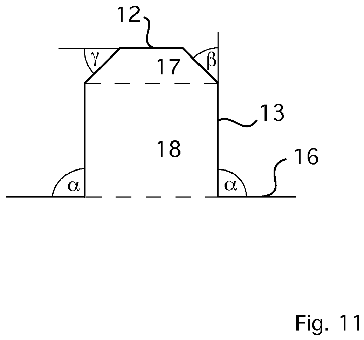

Es ist in den Figuren 4 und 6 bis 10 zu erkennen, dass das Formteil 30 jeweils einen großen Umformgrad aufweist. Fig. 11 veranschaulicht die mit dem hohen Umformgrad verbundene erste Richtungsänderung zwischen der Decke 12 und dem ersten Abschnitt des Mantels 13, der den ersten Abschnitt 17 des Hohlraums 11 begrenzt, eine zweite Richtungsänderung zwischen dem ersten Abschnitt des Mantels 13 und dem zweiten Abschnitt des Mantels 13, der den zweiten Abschnitt 18 des Hohlraums 11 begrenzt, und eine dritte Richtungsänderung zwischen dem zweiten Abschnitt des Mantels 13 und der Basis 16. Die dritte Richtungsänderung ist durch einen Neigungswinkel α, die zweite Richtungsänderung durch einen Neigungswinkel β und die erste Richtungsänderung durch einen Neigungswinkel γ gekennzeichnet. Der Neigungswinkel α beträgt 90°, die Neigungswinkel β und γ betragen jeweils 45°.

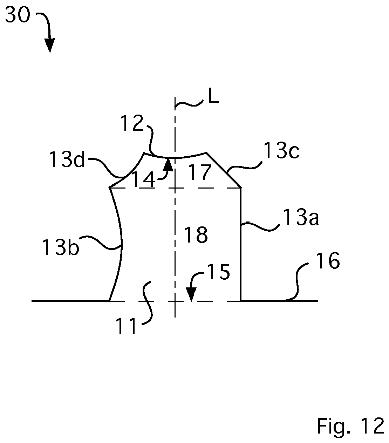

Fig. 12 zeigt ein anderes Formteil 30, dass die erfindungsgemäße Eingabevorrichtung anstelle des in den Figuren 4 und 6 bis 10 gezeigten Formteils aufweisen kann. Das Formteil 30 besitzt einen Hohlraum 11, der von der Decke 12 und einem Mantel 13 begrenzt wird. Der Hohlraum 11 besitzt eine erste Stirnseite 14, die von der Decke 12 verschlossen ist. Er besitzt ferner eine zweite Stirnseite 15, die offen ist und an der eine Basis 16 ausgebildet ist, die sich von dem Hohlraum 11 weg erstreckt. Der Hohlraum 11 weist einen ersten Abschnitt 17 und einen zweiten Abschnitt 18 auf, wobei, bezogen auf die Längsachse L des Formteils 30, sich der erste Abschnitt 17 von der ersten Stirnseite 14 bis zum zweiten Abschnitt 18 und der zweite Abschnitt 18 sich vom ersten Abschnitt 17 bis zur zweiten Stirnseite 15 erstreckt. Bezogen auf die Längsachse L des Hohlraums 11 ist der zweite Abschnitt 18 länger als der erste Abschnitt 17. Der Hohlraum kann wenigstens 4 cm, bevorzugt wenigstens 5 cm hoch sein und an der zweiten Stirnseite 15 einen Durchmesser von wenigstens 4 cm, bevorzugt wenigstens 5 cm haben. Die Decke 12 ist konkav gewölbt. Der Mantel 13 weist ein erstes Segment 13a und ein zweites Segment 13b auf, die den zweiten Abschnitt 18 des Hohlraums 11 begrenzen. Das erste Segment 13a und das zweite Segment 13b erstrecken sich jeweils von der zweiten Stirnseite 15 bis zur Grenzfläche zwischen dem ersten Abschnitt 17 und den zweiten Abschnitt 18 des Hohlraumes 11. Es ist in Fig. 12 zu erkennen, dass der zweite Abschnitt 13b konkav gewölbt ist, während der erste Abschnitt 13a keine Wölbung aufweist. Der Mantel 13 weist ferner ein drittes Segment 13c und ein viertes Segment 13d auf, die den ersten Abschnitt 17 des Hohlraums 11 begrenzen. Das dritte Segment 13c und das vierte Segment 13d erstrecken sich jeweils von der ersten Stirnseite 14 bis zur Grenzfläche zwischen dem ersten Abschnitt 17 und den zweiten Abschnitt 18 des Hohlraumes 11. Es ist in Fig. 12 zu erkennen, dass der vierte Abschnitt 13d konkav gewölbt ist, während der dritte Abschnitt 13c keine Wölbung aufweist.

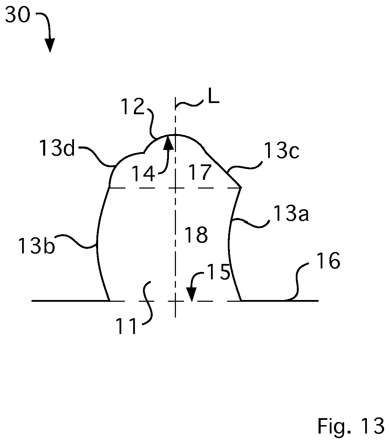

Fig. 13 zeigt ein noch anderes Formteil 30, dass die erfindungsgemäße Eingabevorrichtung anstelle des in den Figuren 4 und 6 bis 10 gezeigten Formteils aufweisen kann. Das in Fig. 13 gezeigte Formteil entspricht dem in Fig. 12 gezeigten Formteil, außer dass das erste Segment 13a konkav gewölbt, das zweite Segment 13b konvex gewölbt ist, das vierte Segment 13d konvex gewölbt ist und die Decke 12 konvex gewölbt ist.

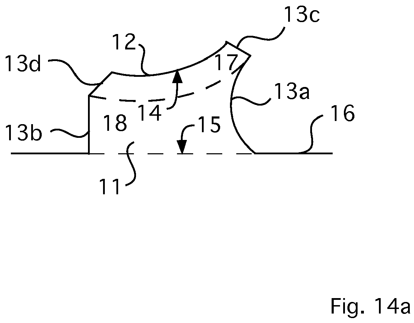

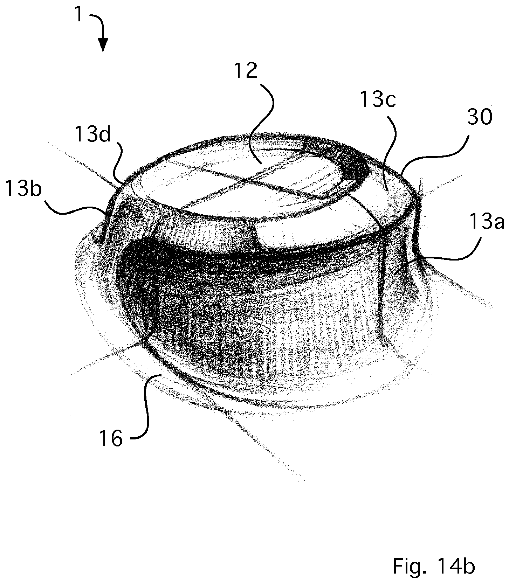

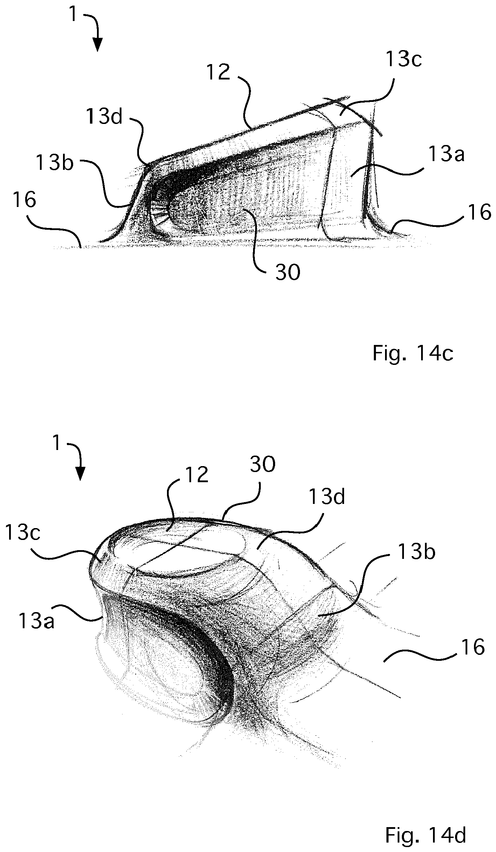

Die in Fig. 14 gezeigten Darstellungen einer siebenten Ausführungsform einer erfindungsgemäßen Eingabevorrichtung 1 veranschaulichen, dass die Wandungen 13 des Formteils 30 ergonomisch ausgebildet sind. Das Formteil 30 der siebenten Ausführungsform entspricht dem in Fig. 12 gezeigten Formteil, außer dass das erste Segment 13a konkav gewölbt, das zweite, dritte und vierte Segment 13b, 13c 13d nicht gewölbt sind und die Decke 12 konkav gewölbt ist. Außerdem ist die Decke 12, bezogen auf die Basis 16 geneigt, weil die Ausdehnung des Mantels 13 an einer ersten Achse, die parallel zur Längsachse L und durch das zweite Segment 13b und das vierte Segment 13d verläuft, geringer als eine zweite Achse ist, die parallel zur Längsachse L und durch das erste Segment 13a und das dritte Segment 13c verläuft.

### Bezugszeichenliste

- 1: Eingabevorrichtung
- 2: Trägerfolie
- 3: erste Flächenseite
- 4: berührungsempfindlichen Sensor
- 5: OLED
- 5a: LED
- 6: erste Leiterbahn
- 7: zweite Leiterbahn
- 8: Schutzschicht
- 9: Verbundfolie
- 9': Verbundfolie
- 10: zweite Flächenseite
- 11: Hohlraum
- 12: Decke
- 13: Mantel
- 13a-d: Segment des Mantels 13
- 14: erste Stirnseite
- 15: zweite Stirnseite
- 16: Basis
- 17: erster Abschnitt
- 18: zweiter Abschnitt
- 20: Kunststoffmaterial
- 21: erster berührungsempfindlicher Sensor
- 22: zweiter berührungsempfindlicher Sensor
- 26: erste Leiterbahn
- 27: zweite Leiterbahn
- 28: Kontaktelement
- 29: gestalterisches Element
- 30: Formteil
- 31: Spritzgussteil
- 41: erster berührungsempfindlicher Sensor
- 42: zweiter berührungsempfindlicher Sensor
- 43: OLED
- 46: erste Leiterbahn
- 47: zweite Leiterbahn
- 48: dritte Leiterbahnen

## Patentansprüche

1. Eingabevorrichtung zur Steuerung eines elektronischen Gerätes, **dadurch gekennzeichnet, dass** sie ein dreidimensionales Formteil (30) aus einer umgeformten Verbundfolie (9, 9') aufweist, wobei die Verbundfolie (9, 9') ein Verbund ist, der eine Kunststoff-Trägerfolie (2), ein oder mehrere Funktionselemente (4, 5, 5a, 21, 22, 41, 42, 43) und eine oder mehrere Leiterbahnen (6, 7, 26, 27, 46, 47, 48) zur elektrischen Kontaktierung der Funktionselemente (4, 5, 5a, 21, 22, 41, 42, 43) aufweist, wobei die Funktionselemente (4, 5, 5a, 21, 22, 41, 42, 43) und die Leiterbahnen (6, 7, 26, 27, 46, 47, 48) auf die Trägerfolie (2) aufgebracht sind, die Funktionselemente (4, 5, 5a, 21, 22, 41, 42, 43) jeweils eine elektrische und/oder elektronische Komponente sind und zumindest eines der Funktionselemente (4, 5, 5a, 21, 22, 41, 42, 43) ein Eingabemittel ist.

2. Eingabevorrichtung nach Anspruch 1, **dadurch gekennzeichnet, dass** eines oder mehrere der Funktionselemente (4, 5, 21, 22, 41, 42, 43) schichtförmig sind.

3. Eingabevorrichtung nach Anspruch 1 oder Anspruch 2, **dadurch gekennzeichnet, dass** der Verbund eine Schutzschicht (8) aufweist, wobei die Funktionselemente (4, 5) und die Leiterbahnen (6, 7) zwischen der Trägerfolie (2) und der Schutzschicht (8) angeordnet sind.

4. Eingabevorrichtung nach Anspruch 1 oder Anspruch 2, **dadurch gekennzeichnet, dass** das Formteil (30) mit einem Kunststoffmaterial (20) verbunden ist, wobei das zumindest eine Funktionselement (4, 5, 5a, 21, 22, 41, 42, 43) zwischen der Trägerfolie (2) und dem Kunststoffmaterial (20) angeordnet ist.

5. Eingabevorrichtung nach einem der vorstehenden Ansprüche, **dadurch gekennzeichnet, dass** das Formteil (30) einen Hohlraum (11) mit einer Decke (12) besitzt, wobei die Decke (12) ein erstes Funktionselement (4, 21, 41) aufweist.

6. Eingabevorrichtung nach Anspruch 5, **dadurch gekennzeichnet, dass** der Hohlraum (11) einen an die Decke (12) angrenzenden Mantel (13) aufweist, wobei der Mantel (13) ein oder mehrere zweite Funktionselemente (5, 5a, 22, 42, 43) aufweist.

7. Eingabevorrichtung nach Anspruch 6, **dadurch gekennzeichnet, dass** das oder die zweiten Funktionselemente (5, 5a, 22, 42, 43), die der Mantel (13) aufweist, mittels Leiterbahnen (6, 26, 46) mit dem ersten Funktionselement (4, 21, 41), das die Decke (12) aufweist, verbunden sind.

8. Eingabevorrichtung nach einem der Ansprüche 5 bis 7, **dadurch gekennzeichnet, dass** es eine Basis (16) aufweist, die an den Mantel (13) angrenzt, wobei die Basis (16) eine oder mehrere dritte Funktionselemente aufweist.

9. Eingabevorrichtung nach Anspruch 8, **dadurch gekennzeichnet, dass** das oder die zweiten Funktionselemente (5, 5a, 22), die der Mantel (13) aufweist, mittels Leiterbahnen (7, 27), mit dem oder den dritten Funktionselementen, die die Basis (16) aufweisen, elektrisch verbunden sind.

10. Eingabevorrichtung nach einem der Ansprüche 5 bis 9, **dadurch gekennzeichnet, dass** das erste Funktionselement (4, 21, 41) ein berührungsempfindlicher Sensor ist und dass zumindest ein Teil der zweiten Funktionselemente (22, 42, 43) berührungsempfindliche Sensoren sind.

11. Eingabevorrichtung nach Anspruch 10, **dadurch gekennzeichnet, dass** zumindest ein Teil der zweiten Funktionselemente (22, 42, 43) in Umfangsrichtung des Mantels (13) voneinander beabstandet über den Mantel (13) verteilt ist.

12. Eingabevorrichtung nach Anspruch 10 oder Anspruch 11, **dadurch gekennzeichnet, dass** zumindest ein Teil der zweiten Funktionselemente (22, 42, 43) streifenförmig ausgebildet ist und dass die streifenförmig ausgebildeten Funktionselemente (22, 42, 43) so in dem Mantel (13) angeordnet sind, dass ihre Längsachse quer zur Umfangsrichtung des Mantels (13) verläuft.

13. Verfahren zur Herstellung einer Eingabevorrichtung zur Steuerung eines elektronischen Gerätes gemäß einem der Ansprüche 1 bis 12, **dadurch gekennzeichnet, dass** das Verfahren die Schritte umfasst:
(a) Bereitstellen einer Kunststoff-Trägerfolie (2);
(b) Herstellen einer Verbundfolie (9, 9'), wobei das Herstellen der Verbundfolie (9, 9') das Aufbringen eines oder mehrerer Funktionselemente (4, 5, 5a, 21, 22, 41, 42, 43) und/oder einer oder mehrere Leiterbahnen (6, 7, 46, 47, 48) auf die Trägerfolie (2) umfasst; und
(c) Umformen der Verbundfolie (9, 9') zu einem Formteil (30).

14. Verfahren nach Anspruch 13, **dadurch gekennzeichnet, dass** die Trägerfolie (2) in Schritt (a) so bereitgestellt wird, dass ihre erste Flächenseite (3) in einer Ebene liegt; das oder die Funktionselemente (4, 5, 5a, 21, 22, 41, 42, 43) in Schritt (b) auf die erste Flächenseite (3) aufgebracht werden; und die Verbundfolie (9, 9') in Schritt (c) zu einem Formteil (30) umgeformt wird.

15. Verfahren nach Anspruch 13 oder Anspruch 14, **dadurch gekennzeichnet, dass** in Schritt (b) eine Schutzschicht aufgebracht wird, so dass die Funktionselemente (4, 5) und die Leiterbahnen (6, 7) zwischen der Trägerfolie (2) und der Schutzschicht (8) angeordnet sind, oder dass im Anschluss an Schritt (c) das Formteil (30) mit einem Kunststoffmaterial verbunden wird, so dass die Funktionselemente (4, 5, 5a, 21, 22, 41, 42, 43) und die Leiterbahnen (6, 7, 26, 27, 46, 47, 48) zwischen der Trägerfolie (2) und dem Kunststoffmaterial angeordnet sind.
